# EUROPEAN PATENT APPLICATION

(11) **EP 4 814 377 A1**
(43) Date of publication of application: **30.09.2026**
(21) Application number: 26167209.1
(22) Date of filing: 24.03.2026
(51) Int. Cl.: F21V 23/00, H05K 1/02, H05K 3/00, H05K 1/181

(54) **SUBSTRATE FOR MOUNTING PLURALITY OF LIGHT SOURCES, LIGHT SOURCE MODULE, AND EXPOSURE DEVICE**

(30) Priority: 26.03.2025 JP 2025052546
(71) Applicant: Nichia Corporation, Anan-shi, Tokushima-ken 774-8601 (JP)
(72) Inventor: SEGAWA, Koki, Anan-shi, Tokushima, 774-8601 (JP); SAGAWA, Takehiro, Anan-shi, Tokushima, 774-8601 (JP)
(74) Representative: Betten & Resch

(57) **Abstract**

A substrate on which a plurality of light sources can be mounted. The substrate including: a base including a base portion having a flat surface, and a plurality of protrusions, each of which is surrounded by the flat surface and has an upper surface located above the flat surface; an insulating member arranged on the flat surface, the insulating member having a thermal conductivity lower than a thermal conductivity of the base; and a wiring arranged on the insulating member. The plurality of protrusions include, in a top view, a first protrusion located at a center and having a first upper surface, and two or more second protrusions located outside the first protrusion, each of which has a second upper surface. The second upper surface having an area smaller than an area of the first upper surface.

## Description

### CROSS-REFERENCE TO RELATED APPLICATION

This application claims priority to Japanese Patent Application No. 2025-052546, filed on March 26, 2025, the disclosure of which is hereby incorporated by reference in its entirety.

### TECHNICAL FIELD

The present disclosure relates to a substrate on which a plurality of light sources can be mounted, a light source module, and an exposure device.

### BACKGROUND

A light source module including a plurality of light sources can be used in a light-emitting device such as a lighting device and an exposure device. An example of the light source module includes a substrate on which the plurality of light sources can be mounted, in addition to the plurality of light sources. The substrate can have a heat dissipation structure for transferring heat generated from the plurality of light sources to outside of the substrate during driving. Japanese Patent Publication Nos. 2009-289772 and 2022-180570 describe examples of the substrate having a heat dissipation structure.

In the substrate described in Japanese Patent Publication No. 2009-289772, a plurality of LED modules are mounted on one of two surfaces located on opposite sides of the substrate, and a heat dissipation member having a plurality of protrusions protruding in a direction away from the substrate is provided on the other surface. The surface areas of the protrusions increase as the protrusions are positioned closer to the center. In the substrate described in Japanese Patent Publication No. 2022-180570, a plurality of light-emitting elements are mounted on the surface of the substrate, and a plurality of heat dissipators are embedded in the substrate. The size of the heat dissipator at the center is larger than the sizes of the other heat dissipators.

### SUMMARY

In a case in which the plurality of light sources are mounted on the substrate, the temperatures of the plurality of light sources during driving depend on the heat dissipation performance of the substrate. The present disclosure provides a substrate that can appropriately control the temperatures of a plurality of light sources during driving.

In one embodiment, a substrate of the present disclosure is a substrate on which a plurality of light sources can be mounted, the substrate including: a base including a base portion having a flat surface, and a plurality of protrusions, each of which is surrounded by the flat surface and has an upper surface located above the flat surface; an insulating member arranged on the flat surface, the insulating member having a thermal conductivity lower than a thermal conductivity of the base; and a wiring arranged on the insulating member, in which the plurality of protrusions include, in a top view, a first protrusion located at a center and having a first upper surface, and two or more second protrusions located outside the first protrusion, each of which has a second upper surface, the second upper surface having an area smaller than an area of the first upper surface.

In one embodiment, a light source module of the present disclosure includes the substrate described above, and the plurality of light sources mounted on the substrate, in which the plurality of light sources include a first light source mounted on the first upper surface, and two or more second light sources, each of which is mounted on the second upper surface.

An exposure device of one embodiment according to the present disclosure includes the light source module described above.

According to an embodiment of the present disclosure, a substrate that can appropriately control the temperatures of a plurality of light sources during driving can be provided.

### BRIEF DESCRIPTION OF DRAWINGS

FIG. 1A is a perspective view schematically illustrating a configuration of a light source module according to an exemplary embodiment of the present disclosure.
FIG. 1B is a perspective view schematically illustrating a configuration example of a substrate included in the light source module illustrated in FIG. 1A.
FIG. 1C is a perspective view schematically illustrating a configuration in which a plurality of wirings are omitted from the substrate illustrated in FIG. 1B.
FIG. 1D is a perspective view schematically illustrating a configuration in which an insulating member and the plurality of wirings are omitted from the substrate illustrated in FIG. 1B.
FIG. 2A is a cross-sectional view schematically illustrating a part of the configuration of the light source module illustrated in FIG. 1A.
FIG. 2B is a cross-sectional view schematically illustrating another part of the configuration of the light source module illustrated in FIG. 1A.
FIG. 3A is a top view schematically illustrating the configuration of the light source module illustrated in FIG. 1A.
FIG. 3B is a top view schematically illustrating a configuration in which the plurality of wirings and the plurality of light sources are omitted from the light source module illustrated in FIG. 1A.
FIG. 4 is a cross-sectional view schematically illustrating a configuration example of the light source included in the light source module illustrated in FIG. 1A.
FIG. 5A is a top view schematically illustrating a first modified example of the light source module according to the present embodiment.
FIG. 5B is a schematic cross-sectional view schematically illustrating a part of a second modified example of the light source module according to the present embodiment.
FIG. 5C is a top view schematically illustrating a third modified example of the light source module according to the present embodiment.
FIG. 5D is a top view schematically illustrating a fourth modified example of the light source module according to the present embodiment.
FIG. 5E is a schematic cross-sectional view schematically illustrating a part of a fifth modified example of the light source module according to the present embodiment.
FIG. 5F is a perspective view schematically illustrating a configuration in which the plurality of wirings are omitted from a substrate included in the light source module illustrated in FIG. 5E.
FIG. 6 is a diagram schematically illustrating a configuration of an exposure device according to an exemplary embodiment of the present disclosure.

### DETAILED DESCRIPTION

A substrate on which a plurality of light sources can be mounted, a light source module, and an exposure device according to embodiments of the present disclosure will be described below with reference to the accompanying drawings. Parts having the same reference characters appearing in the plurality of drawings indicate identical or equivalent parts.

Embodiments to be described below are exemplified to embody a technical idea of the present invention, and the present invention is not limited to the following. A description of a dimension, a material, a shape, a relative arrangement, and the like of a component is not intended to limit the scope of the present invention thereto but intended to be illustrative. Sizes and a positional relationship of members illustrated in the drawings can be exaggerated to facilitate understanding.

In the present specification or the scope of claims, with respect to a polygon such as a triangle or a quadrangle, a shape in which a corner rounding or chamfering is performed at corners of the polygon is also referred to as the polygon. A polygon also refers to a shape obtained when not only a corner (an end of a side) but also an intermediate portion of a side is processed. In other words, a shape partially processed while retaining a polygon shape as a base is included in an interpretation of "polygon" described in the present specification and the scope of claims. In this specification or the scope of the claims, when there are a plurality of components identified by a certain term and each of the components is to be expressed separately, an ordinal number such as "first" and "second" may be added in front of each of the terms of the components. The ordinal numbers "first" and "second" are used merely for distinguishing two elements from each other. An order of the ordinal numbers has no special meaning. A term of a component provided with the same ordinal number may not refer to the same component between the specification and the scope of the claims.

In the accompanying drawings, for reference, an X-axis, a Y-axis, and a Z-axis orthogonal to one another are schematically illustrated. The direction of an arrow on the X-axis is referred to as a +X direction, and an opposite direction to the +X direction is referred to as a -X direction. When the ±X directions are not distinguished, the ±X directions are simply referred to as X directions. The same applies to a Y direction and a Z direction. This does not limit the orientation of the substrate and the light source module during use, and the substrate and the light source module may be in any orientation.

### Embodiments

### Light Source Module

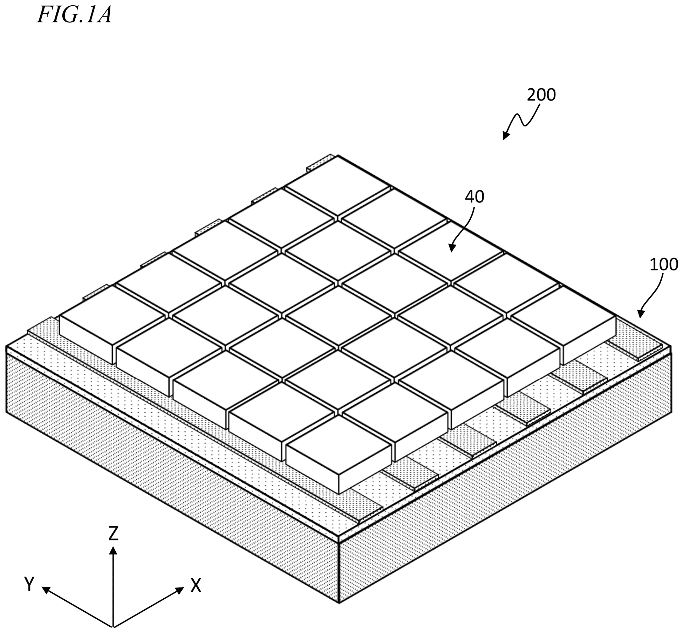

First, with reference to FIGS. 1A to 1D, 2A and 2B, 3A and 3B, and 4, a configuration example of a light source module according to an embodiment of the present disclosure will be described. The light source module can be used, for example, in a light-emitting device such as a lighting device and an exposure device.

FIG. 1A is a perspective view schematically illustrating a configuration of the light source module according to an exemplary embodiment of the present disclosure. A light source module 200 illustrated in FIG. 1A includes a substrate 100 and a plurality of light sources 40 mounted on the substrate 100. The light source module 200 emits irradiation light obtained from light emitted by each of the plurality of light sources 40 in the +Z direction. In the present specification, the term "light" includes not only visible light (wavelength from 400 nm to 750 nm) but also ultraviolet rays (wavelength from 100 nm to 400 nm) and infrared rays (wavelength from 750 nm to 1 mm). In the present specification, ultraviolet rays are also referred to as "ultraviolet light", and infrared rays are also referred to as "infrared light".

In the illustrated example, the plurality of light sources 40 are arrayed in five rows and five columns, with the X direction and the Y direction defined as a row direction and a column direction, respectively, but the array is not limited to this example. The number of rows can be, for example, three or more, and the number of columns can be, for example, three or more. In the illustrated example, the plurality of light sources 40 are arranged to form rows and columns within a rectangular region, but the array form of the light sources 40 is not limited to this example. The plurality of light sources 40 can be arranged, for example, in a matrix pattern, a concentric pattern, or a triangular lattice pattern within a region having any shape such as a rectangular shape, a circular shape, an elliptical shape, or a rhombic shape. The shape of the region in which the plurality of light sources 40 are arranged can be determined in accordance with the shape of the irradiation target. For example, in a case in which the irradiation target has a disk shape, the region in which the plurality of light sources 40 are arranged is a circular region. In the illustrated example, the plurality of light sources 40 are arranged two-dimensionally, but the arrangement is not limited to this example. The plurality of light sources 40 can be arranged one-dimensionally in either a row or a column.

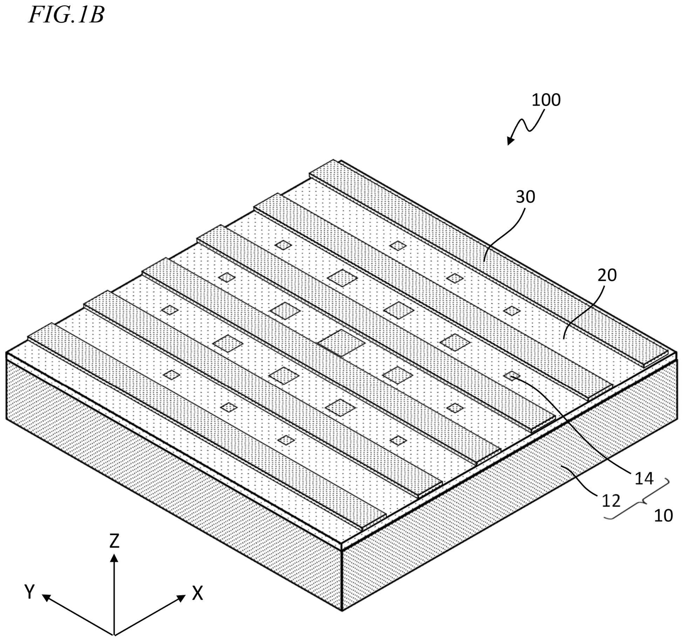

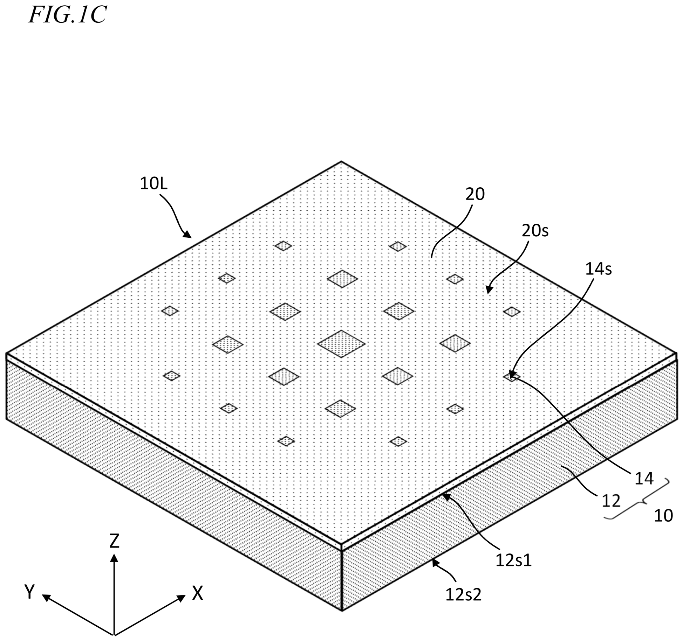

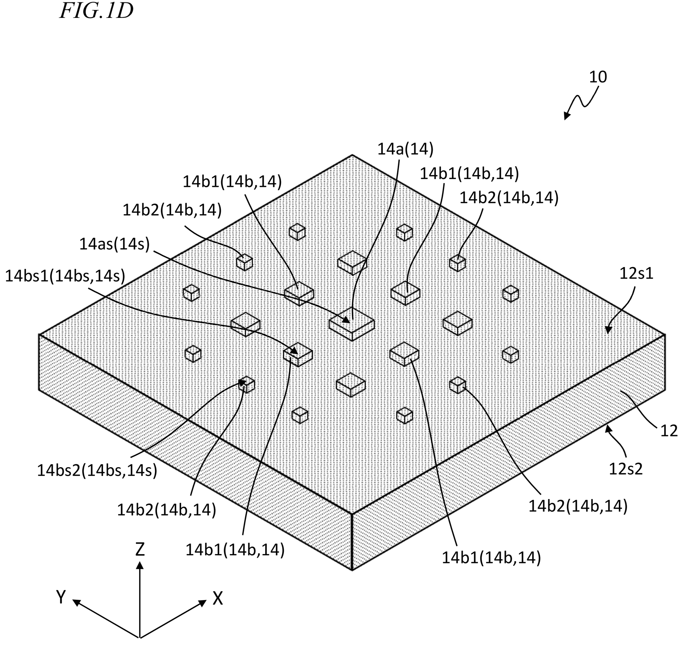

FIG. 1B is a perspective view schematically illustrating a configuration example of the substrate 100 included in the light source module 200 illustrated in FIG. 1A. The substrate 100 includes a base 10 including a plurality of protrusions 14, an insulating member 20 arranged on the base 10, and a plurality of wirings 30 for supplying power to the plurality of light sources 40. FIG. 1C is a perspective view schematically illustrating a configuration in which the plurality of wirings 30 are omitted from the substrate 100 illustrated in FIG. 1B. FIG. 1D is a perspective view schematically illustrating a configuration in which the insulating member 20 and the plurality of wirings 30 are omitted from the substrate 100 illustrated in FIG. 1B.

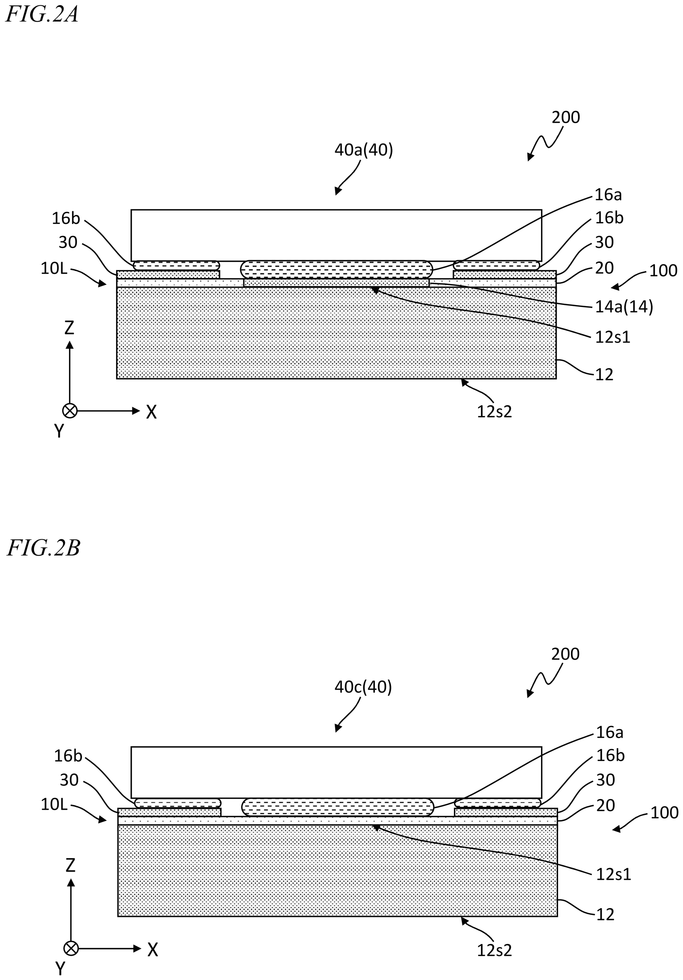

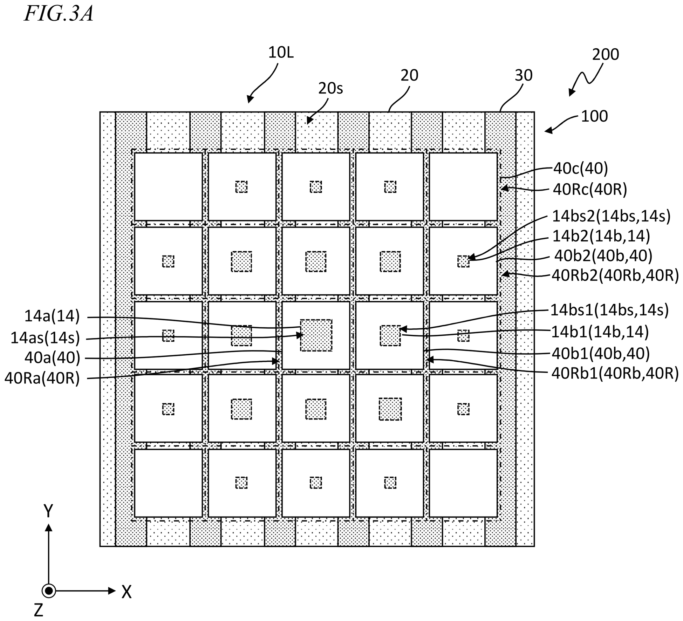

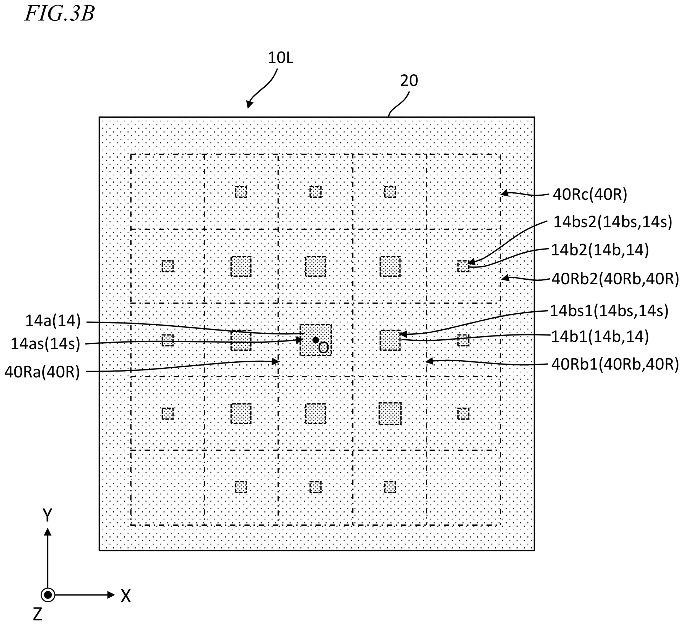

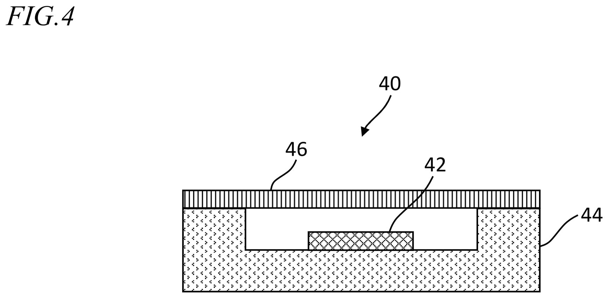

FIG. 2A is a cross-sectional view schematically illustrating a part of the configuration of the light source module 200 illustrated in FIG. 1A. FIG. 2B is a cross-sectional view schematically illustrating another part of the configuration of the light source module 200 illustrated in FIG. 1A. FIG. 3A is a top view schematically illustrating the configuration of the light source module 200 illustrated in FIG. 1A. FIG. 3B is a top view schematically illustrating a configuration in which the plurality of wirings 30 and the plurality of light sources 40 are omitted from the light source module 200 illustrated in FIG. 1A. The broken line illustrated in FIG. 3A represents a component located below the plurality of light sources 40. A region surrounded by the one-dot chain line illustrated in FIGS. 3A and 3B represents a mounting region 40R of the light source 40. A definition of the mounting region 40R will be described below. FIG. 4 is a cross-sectional view schematically illustrating a configuration example of the light source 40 included in the light source module 200 illustrated in FIG. 1A.

Operating characteristics of the light source 40 during driving depend on a temperature thereof. Accordingly, appropriate control of the temperature of the light source 40 during driving is needed. The operating characteristics of the light source 40 can be, for example, a wavelength and an intensity of light emitted from the light source 40. In a case in which the plurality of light sources 40 are arrayed and mounted on a substrate in which the thermal conductivity or the thermal resistance is uniformly distributed regardless of the position on the plane, during driving, the temperatures of the light sources 40 tend to be higher as the light sources 40 are positioned closer to the center and tend to be lower as the light sources 40 are positioned farther from the center. As a possible reason for this, for example, heat generated from the plurality of light sources 40 during driving tend to accumulate at the center of the substrate. When there are temperature differences between the plurality of light sources 40 during driving, the wavelength or the intensity of the light emitted from the plurality of light sources 40 varies depending on the position and the temperature of each of the light sources 40. As a result, even when irradiation light having a uniform wavelength and a uniform intensity is intended to be emitted from the light source module, unevenness in the wavelength or unevenness in the intensity can occur in the irradiation light.

In contrast, in the light source module 200 according to the present embodiment, the substrate 100 on which the plurality of light sources 40 can be mounted includes a heat dissipation layer 10L including the plurality of protrusions 14 and the insulating member 20, as illustrated in FIG. 1C. In the heat dissipation layer 10L, the thermal conductivity or the thermal resistance is non-uniformly distributed depending on the arrangement of the light sources 40. Accordingly, during driving, the temperatures of the plurality of light sources 40 can be appropriately controlled so that the plurality of light sources 40 have desired operating characteristics during driving. This can reduce unevenness in the wavelength or reduce unevenness in the intensity.

The details of the base 10, the insulating member 20, and the plurality of wirings 30 included in the substrate 100, and the plurality of light sources 40 will be described below.

### Base 10

As illustrated in FIG. 1D, the base 10 includes a base portion 12 and the plurality of protrusions 14. The base portion 12 has an upper surface 12s1 and a lower surface 12s2 located opposite to the upper surface 12s1. The upper surface 12s1 can be, for example, a flat surface parallel to an XY plane. The same applies to the lower surface 12s2. A thickness direction of the base portion 12 is parallel to the Z direction. Each protrusion 14 has an upper surface 14s. The upper surface 14s of each protrusion 14 is located above the upper surface 12s1 of the base portion 12. In a top view as viewed in a normal direction of the upper surface 12s1 of the base portion 12, each protrusion 14 is surrounded by the upper surface 12s1 of the base portion 12.

In the present specification, the term "flat surface" means a surface having a flatness of 10 µm or less. In the present specification, the +Z direction, which is parallel to the thickness direction of the base portion 12 and is a direction from the inside of the base portion 12 toward the upper surface 12s1, is also referred to as an "upper side". The -Z direction, which is parallel to the thickness direction of the base portion 12 and is a direction from the inside of the base portion 12 toward the lower surface 12s2, is also referred to as a "lower side". The term "normal direction to a surface" means a direction perpendicular to the surface and away from a subject having the surface. As illustrated in FIG. 1C, the insulating member 20 is arranged on the upper surface 12s1 of the base portion 12. The thermal conductivity of the insulating member 20 is lower than the thermal conductivity of the base 10. More specifically, the thermal conductivity of the insulating member 20 is lower than the thermal conductivity of the base portion 12 and lower than the thermal conductivity of the protrusion 14. The thermal conductivity can be measured by, for example, a laser flash method. Even without actual measurement, the thermal conductivity can be known from a published value when a material is identified.

In a case in which the thermal resistance is used instead of the thermal conductivity, the thermal resistance of the insulating member 20 is higher than a thermal resistance of the base 10. More specifically, the thermal resistance of the insulating member 20 is higher than the thermal resistance of the base portion 12 and is also higher than the thermal resistance of the protrusion 14. A thermal resistance is defined by dividing a thickness of a target member by a thermal conductivity.

As illustrated in FIGS. 2A and 2B, the plurality of light sources 40 are supported by the protrusions 14 or the insulating member 20 through a bonding member 16a. The bonding member 16a can be, for example, a solder material or a sintered material. Instead of the bonding member 16a, a thermally conductive grease having heat conductivity and flexibility can be used.

The plurality of light sources 40 are in thermal contact with the plurality of protrusions 14 or the insulating member 20 through the bonding member 16a or the thermally conductive grease. Heat generated from the plurality of light sources 40 during driving is transferred to the base portion 12 through the plurality of protrusions 14 or the insulating member 20. Therefore, a layer including the plurality of protrusions 14 and the insulating member 20 functions as the heat dissipation layer 10L. The substrate 100 can be regarded as having the heat dissipation layer 10L. In a case in which the base 10 is arranged on a heat sink, and the lower surface 12s2 of the base portion 12 is in thermal contact with the heat sink, heat having been transferred to the base portion 12 is transferred to the heat sink.

In the heat dissipation layer 10L, the arrangement and the shape of the protrusions 14 are appropriately configured, so that the thermal conductivity or the thermal resistance can be non-uniformly distributed according to the arrangement of the light sources 40. Examples of the arrangement and the shape of the protrusions 14 are as follows.

As illustrated in FIG. 1D, the plurality of protrusions 14 include a first protrusion 14a located at the center and two or more second protrusions 14b located outward of the first protrusion 14a in a top view. The first protrusion 14a can be located, for example, between two of the second protrusions 14b included in the two or more second protrusions 14b. The two or more second protrusions 14b include at least one second inner protrusion 14b1 located closer to the first protrusion 14a and at least one second outer protrusion 14b2 located outside the second inner protrusions 14b1.

In the illustrated example, the at least one second inner protrusion 14b1 surrounds the first protrusion 14a and includes eight second protrusions 14b having the same shape. Some or all of these eight second protrusions 14b can have different shapes. The at least one second outer protrusion 14b2 is located at an end and includes 12 second protrusions 14b having the same shape. Some or all of these 12 second protrusions 14b can have different shapes. The two or more second protrusions 14b are arranged so as to surround the first protrusion 14a.

The first protrusion 14a has a first upper surface 14as. Each of the two or more second protrusions 14b has a second upper surface 14bs. The area of the second upper surface 14bs is different from the area of the first upper surface 14as. The shape of the first upper surface 14as is square, but can be, for example, rectangular, circular, elliptical, or hexagonal. The same applies to the shape of the second upper surface 14bs. The shapes of the upper surfaces 14as and 14bs can be determined according to the shapes of the light sources 40 in a top view, which are supported by the protrusions 14a and 14b, for example.

Of the two or more second protrusions 14b, the second inner protrusion 14b1 has a second inner upper surface 14bs1, and the second outer protrusion 14b2 has a second outer upper surface 14bs2. In a top view, the two or more second upper surfaces 14bs include at least one second inner upper surface 14bs1 closer to the first upper surface 14as and at least one second outer upper surface 14bs2 located outward or the second inner upper surface 14bs1. The area of the second outer upper surface 14bs2 is different from the area of the second inner upper surface 14bs1.

In the illustrated example, the area of each second upper surface 14bs is smaller than the area of the first upper surface 14as. The area of the second outer upper surface 14bs2 is smaller than the area of the second inner upper surface 14bs1. Thus, the area of the upper surface 14s of each protrusion 14 is greater as the protrusion 14 is positioned closer to the center, and is less as the protrusion 14 is positioned farther from the center. In the illustrated example, the second protrusions 14b are not located at four corners, but the arrangement is not limited to this example. The second protrusions 14b can be located at four corners.

As described above, in a case in which the plurality of light sources 40 are mounted on the substrate in which the thermal conductivity or the thermal resistance is uniformly distributed regardless of the position in the plane, the temperatures of the light sources 40 tend to be higher as the light sources 40 are positioned closer to the center, and tend to be lower as the light sources 40 are positioned farther from the center. In contrast, in the heat dissipation layer 10L illustrated in FIG. 1C, as the area of the upper surface 14s of the protrusion 14 becomes larger, heat generated from the light sources 40 during driving is more effectively transferred to the base portion 12, so that the temperature difference between the plurality of light sources 40 can be reduced. As a result, in the irradiation light emitted from the light source module 200, it becomes possible that unevenness in the wavelength or unevenness in the intensity is less likely to occur.

However, depending on the application, the area of the upper surface 14s of each protrusion 14 does not necessarily have to increase as the protrusion 14 is positioned closer to the center, or decrease as the protrusion 14 is positioned farther from the center. In a case in which the distribution of the wavelength and/or the intensity of the irradiation light emitted from the light source module 200 is intentionally changed, the temperatures of the plurality of light sources 40 can be controlled accordingly. The area of the upper surface 14s of each protrusion 14 can decrease as the protrusion 14 is positioned closer to the center and increase as the protrusion 14 is positioned farther from the center. Alternatively, the area of the upper surface 14s of some of the protrusions 14 can be constant regardless of the distances from the center. In a case in which the distribution of the wavelength and/or the intensity of the irradiation light is intentionally changed, not only temperatures of a plurality of light sources 40 can be controlled, but also the light source module 200 can be combined with an optical system.

For example, the plurality of protrusions 14 and the base portion 12 can form a single monolithic body. In this case, the plurality of protrusions 14 protrude in the +Z direction from the upper surface 12s1. For example, the base 10 can be fabricated by etching or cutting a surface of a plate-shaped member such as a copper substrate. Alternatively, the base 10 can be fabricated, for example, by molding using a casting mold. Further, the base 10 can be fabricated by forming the plurality of protrusions 14 on the base portion 12 using a plating process.

As will be described below in a modified example, the plurality of protrusions 14 and the base portion 12 can be individual bodies. In this case, the plurality of protrusions 14 are fixed to the upper surface 12s1 of the base portion 12. The plurality of protrusions 14 and the base portion 12 can be formed of the same material or can be formed of different materials.

The protrusions 14 can be formed of a material having an isotropic thermal conductivity of 100 W/m ·K or more, for example. The same applies to the base portion 12. Such a material can be at least one metal material selected from the group consisting of Cu, Al, Au, CuW, CuMo, and Ag, for example. Alternatively, such a material can be a metal matrix composite material in which diamond particles are dispersed in at least one metal material selected from the group consisting of Cu, Al, and Ag, for example. When a material having the isotropic thermal conductivity is used, the protrusions 14 and the base portion 12 can be fabricated without considering the direction.

The dimension of the protrusions 14 in the X direction is, for example, in a range of 0.1 mm to 5 mm, the dimension in the Y direction is, for example, in a range of 0.1 mm to 5 mm, and the dimension in the Z direction can be, for example, in a range of 0.1 mm to 5 mm. The pitch of the protrusions 14 in the X direction can be, for example, in a range of 0.5 mm to 10 mm. The same applies to the pitch of the protrusions 14 in the Y direction. The dimension of the base portion 12 in the X direction is, for example, in a range of 10 mm to 300 mm, the dimension in the Y direction is, for example, in a range of 10 mm to 300 mm, and the dimension in the Z direction can be, for example, in a range of 0.5 mm to 10 mm. These parameters of the protrusions 14 and the base portion 12 can be determined, for example, based on a simulation so that the temperatures of the plurality of light sources 40 can be appropriately controlled during driving.

In the illustrated example, the plurality of protrusions 14 are arranged two-dimensionally, but the arrangement is not limited to this example. The plurality of protrusions 14 can be arranged one-dimensionally, for example. In the illustrated example, the number of the protrusions 14 is smaller than the number of the light sources 40, but the number of the protrusions 14 is not limited to this example. The number of the protrusions 14 can be the same as the number of the light sources 40, or can be larger than the number of the light sources 40. In the illustrated example, the plurality of protrusions 14 are spaced apart from each other, but the arrangement is not limited to this example. For example, in the plurality of protrusions 14, any two of the protrusions 14 adjacent to each other in the Y direction can be connected by a linked portion. The dimension of the linked portion in the X direction can be smaller than the dimension of each of the two protrusions 14 in the X direction.

In the present specification, the first protrusion 14a located at the center is, as illustrated in FIG. 3B, in a top view, the protrusion 14 having the center closest to a reference position O among the plurality of protrusions 14. The reference position O is defined by averaging a plurality of centers of the plurality of protrusions 14 in the X direction and the Y direction. The center of the protrusion 14 is defined by the center of gravity of the protrusion 14.

In the illustrated example, in the plurality of protrusions 14 arrayed in five rows and five columns excluding four corners, the number of the protrusions 14 having the center closest to the reference position O is one. The center of this one protrusion 14 coincides with the reference position O. However, there is no limitation to this example. For example, as will be described below in the modified example, in the plurality of protrusions 14 arrayed in six rows and six columns excluding four corners, the number of protrusions 14 having the center closest to the reference position O is four. Thus, the number of the first protrusions located at the center is one or more.

### Insulating Member 20

As illustrated in FIG. 1C, the insulating member 20 is arranged on the upper surface 12s1 of the base portion 12 so as not to cover the upper surfaces 14s of the protrusions 14. The insulating member 20 surrounds, in a top view, the protrusions 14 without overlapping the upper surfaces 14s of the protrusions 14. Due to the presence of the insulating member 20, the plurality of wirings 30 can be arranged, and the plurality of light sources 40 can be stably arranged.

The insulating member 20 has an upper surface 20s. As illustrated in FIG. 1C, the upper surface 20s of the insulating member 20 is located on the same plane as the upper surfaces 14s of the plurality of protrusions 14. Alternatively, the upper surface 20s of the insulating member 20 can be located below the upper surfaces 14s of the plurality of protrusions 14. In a case in which the light sources 40 can be in thermal contact with the protrusions 14 through, for example, the bonding member or the thermally conductive grease, the upper surface 20s of the insulating member 20 can be located above the upper surfaces 14s of the plurality of protrusions 14.

The insulating member 20 can be formed on the upper surface 12s1 of the base portion 12 by coating or sputtering, for example, depending on a material of the insulating member 20. The insulating member 20 can be formed of an insulating material having the isotropic thermal conductivity of 10 W/m ·K or less, for example. Such an insulating material can be, for example, at least one selected from the group consisting of resin, ceramics, and glass.

### Wiring 30

As illustrated in FIG. 1B, the plurality of wirings 30 are arranged on the insulating member 20. The plurality of wirings 30 are electrically connected to an external power supply device. Because the insulating member 20 is present between the wirings 30 and the base 10, the wirings 30 are not electrically connected to the base 10.

The plurality of wirings 30 are arranged next to each other in the X direction and extend along the Y direction. The plurality of wirings 30 do not overlap the plurality of protrusions 14 in a top view. In a top view, one or more protrusions 14 are located between any two wirings 30 adjacent to each other in the plurality of wirings 30. Different polarities (positive and negative) of the plurality of wirings 30 alternate in the X direction.

As illustrated in FIGS. 2A and 2B, each of the light sources 40 is electrically connected to two corresponding wirings 30 through the bonding member 16b. In this manner, the wirings 30 are electrically connected to the light source 40. The bonding member 16b is separated from the bonding member 16a so as not to be in contact with the bonding member 16a. The dimension of the bonding member 16b in the Z direction is smaller than the dimension of the bonding member 16a in the Z direction by the amount corresponding to the dimension of the wiring 30 in the Z direction. Similarly to the bonding member 16a, the bonding member 16b can be, for example, a solder material or a sintered material.

As will be described below in the modified example, some of the plurality of light sources 40 can be electrically connected in series by a conductive member such as a wire.

The wiring 30 can be formed of at least one metal material selected from the group consisting of Cu, Al, Au, CuW, CuMo, and Ag, for example. The dimension of the wiring 30 in the X direction can be, for example, in a range of 1 mm to 5 mm, the dimension in the Y direction can be, for example, in a range of 30 mm to 100 mm, and the dimension in the Z direction can be, for example, in a range of 0.1 mm to 0.5 mm.

### Light Source 40

As illustrated in FIG. 3A, the plurality of light sources 40 include a first light source 40a mounted on the first upper surface 14as of the first protrusion 14a, and two or more second light sources 40b, each of which is mounted on the second upper surface 14bs of the corresponding second protrusion 14b. The first light source 40a can be located, for example, between two second light sources 40b included in the two or more second light sources 40b. The two or more second light sources 40b include at least one second inner light source 40b1 mounted on the second inner upper surface 14bs1, and at least one second outer light source 40b2 mounted on the second outer upper surface 14bs2. As illustrated in FIG. 3A, the plurality of light sources 40 can further include one or more third light sources 40c mounted on the insulating member 20. The protrusions do not necessarily have to be provided under the third light sources 40c at the four corners away from the first light source 40a.

As illustrated in FIG. 2A, the first light source 40a is supported by the first protrusion 14a through the bonding member 16a. The second light sources 40b are respectively supported by the second protrusions 14b through the bonding member 16a. As illustrated in FIG. 2B, the third light sources 40c are supported by the insulating member 20 through the bonding member 16a.

A specific configuration example of the light sources 40 is as illustrated in FIG. 4. The light source 40 can include, for example, as illustrated in FIG. 4, a light-emitting element 42 that emits light in the +Z direction, a base body 44 that accommodates the light-emitting element 42, and a light-transmissive member 46 bonded to the base body 44, the light-transmissive member 46 transmitting light emitted from the light-emitting element 42.

The light-emitting element 42 can be, for example, a light-emitting diode (LED) or laser diode (LD) in the form of a chip. The base body 44 transmits heat generated from the light-emitting element 42 to outside of the base body 44 during driving. The base body 44 has an internal wiring for supplying power to the light-emitting element 42. The light-emitting element 42 is supplied with electric power from two wirings 30 adjacent to each other through an internal wiring of the base body 44. The base body 44 is bonded not only to the upper surface 14s of the protrusion 14 or to the upper surface 20s of the insulating member 20 but also to the two wirings 30 adjacent to each other. The shape of the base body 44 in a top view is square, but can be, for example, rectangular, circular, elliptical, or hexagonal. The light-transmissive member 46 transmits 60% or more of light emitted from the light-emitting element 42, and preferably transmits 90% or more of the light emitted from the light-emitting element 42. The base body 44 can be formed of, for example, ceramics such as AlN or SiN. The light-transmissive member 46 can be formed of, for example, a light-transmissive material such as glass.

The light source 40 can further include a wavelength conversion member that converts a part or all of the wavelength of the light emitted from the light-emitting element 42. The light source 40 can further include an optical element that collimates, converges, or diverges the light emitted from the light-emitting element 42. The optical element can be, for example, a lens or a diffraction grating. Alternatively, as will be described below in the modified example, the light source 40 may not include the base body 44 or the light-transmissive member 46, and can be the light-emitting element 42 itself.

The light-emitting element 42 can emit purple, blue, green, or red light in a visible region, or infrared or ultraviolet light in an invisible region. A peak wavelength of purple light is in a range of 400 nm to 420 nm. A peak wavelength of blue light is in a range of greater than 420 nm to 495 nm. A peak wavelength of green light is in a range of greater than 495 nm to 570 nm. A peak wavelength of red light is in a range of 605 nm to 750 nm.

The light-emitting element 42 that emits ultraviolet, purple, blue, and green light can include, for example, a nitride semiconductor material such as GaN, InGaN, or AlGaN. The light-emitting element 42 that emits infrared and red light can include an InAlGaP-based, a GaInP-based, a GaAs-based, and an AlGaAs-based semiconductor material.

The light-emitting element 42 can be encapsulated by the base body 44 and the light-transmissive member 46. The encapsulation of the light-emitting element 42 can be, for example, airtight sealing. Regardless of whether the light-emitting element 42 is the LED or the LD, the effect of the airtight sealing increases as the wavelength of light decreases. This is because, in a case in which the light-emitting element 42 is not airtight sealed, but a light emission surface of the light-emitting element 42 is exposed to an external atmosphere, the likelihood that deterioration of the light emission surface progresses during operation due to dust collection increases as a peak wavelength of light is shorter. In a case in which the light source module 200 is sealed by a housing, the light-emitting element 42 does not need to be sealed with the base body 44 or the light-transmissive member 46.

The dimension of the light-emitting element 42 in the X direction can be, for example, in a range of 0.3 mm to 3 mm, the dimension in the Y direction can be, for example, in a range of 0.3 mm to 3 mm, and the dimension in the Z direction can be, for example, in a range of 0.2 mm to 1 mm. The dimension of the light source 40 in the X direction can be, for example, in a range of 2 mm to 10 mm, the dimension in the Y direction can be, for example, in a range of 2 mm to 10 mm, and the dimension in the Z direction can be, for example, in a range of 0.2 mm to 3 mm.

The pitch of the light source 40 in the X direction can be, for example, in a range of 2 mm to 10 mm. The same applies to the pitch of the light source 40 in the Y direction. The minimum gap between light sources 40 adjacent to each other in the X direction can be, for example, in a range of 0.1 mm to 1 mm. The ratio of the minimum gap to the pitch in the X direction can be, for example, in a range of 1% to 50%. The same applies to the minimum gap between the light sources 40 adjacent to each other in the Y direction and to the ratio of the minimum gap to the pitch in the Y direction.

In a case in which these parameters related to the pitch and the gap of the light sources 40 are satisfied, when the temperature difference between the plurality of light sources 40 during driving is small, unevenness in the intensity of the irradiation light emitted from the light source module 200 is less likely to occur. On the other hand, in a case in which these parameters are satisfied, when the plurality of light sources 40 are mounted on a substrate in which the thermal conductivity or the thermal resistance is uniformly distributed regardless of the position on the plane, during driving, the temperatures of the light sources 40 tend to be higher as the light sources 40 are positioned closer to the center, and tend to be lower as the light sources 40 are positioned farther from the center.

Next, the definition of the mounting region 40R of the light source 40 in the present specification will be described. In a case in which the plurality of light sources 40 are two-dimensionally arranged as illustrated in FIG. 3A, the mounting region 40R for the light source 40 in the heat dissipation layer 10L is defined as follows. In a top view, drawing a perpendicular bisector of a line segment connecting the center of the target light source 40 and the center of its adjacent light source 40 is performed for all the adjacent light sources 40. In this manner, a plurality of perpendicular bisectors are obtained. In the heat dissipation layer 10L, a region surrounded by the plurality of perpendicular bisectors corresponds to the mounting region 40R for the target light source 40. For the light source 40 located at the end, a region surrounded by the plurality of perpendicular bisectors is not present. In this case, as the mounting region 40R for the light source 40 located at the end, a region having the same shape as the mounting region 40R of the closest light source 40 is substituted.

As illustrated in FIG. 3B, in the heat dissipation layer 10L, the occupancy ratio of the upper surfaces 14s of the protrusions 14 in the mounting region 40R varies depending on the position of the mounting region 40R. Therefore, the thermal conductivity of the mounting region 40R varies depending on the position of the mounting region 40R. The thermal conductivity of the mounting region 40R is defined by a spatial average value of the thermal conductivity of components in the mounting region 40R. That is, the thermal conductivity of the mounting region 40R is a sum of a value obtained by multiplying the thermal conductivity of the protrusions 14 by the occupancy ratio of the protrusions 14 in the mounting region 40R, and a value obtained by multiplying the thermal conductivity of the insulating member 20 by the occupancy ratio of the insulating member 20 in the mounting region 40R.

As illustrated in FIG. 3B, a plurality of mounting regions 40R include a first mounting region 40Ra located at the center and two or more second mounting regions 40Rb located outside the first mounting region 40Ra. The plurality of mounting regions 40R further include four third mounting regions 40Rc located at four corners. The first light source 40a is mounted on the first mounting region 40Ra. On each of the two or more second mounting regions 40Rb, a corresponding one of the two or more second light sources 40b is mounted. On each of the four third mounting regions 40Rc, a corresponding one of the four third light sources 40c is mounted. The thermal conductivity of each of the second mounting regions 40Rb is different from the thermal conductivity of the first mounting region 40Ra. The thermal conductivity of each of the third mounting regions 40Rc is different from the thermal conductivity of each of the second mounting regions 40Rb, and is also different from the thermal conductivity of the first mounting region 40Ra.

The two or more second mounting regions 40Rb include at least one second inner mounting region 40Rb1 located closer to the first mounting region 40Ra, and at least one second outer mounting region 40Rb2 located outward of the second inner mounting region 40Rb1. The thermal conductivity of the second outer mounting region 40Rb2 is different from the thermal conductivity of the second inner mounting region 40Rb1.

In the illustrated example, the at least one second inner mounting region 40Rb1 surrounds the first mounting region 40Ra, and includes the eight second mounting regions 40Rb having the same shape. The at least one second outer mounting region 40Rb2 is positioned at the ends, and includes the 12 second mounting regions 40Rb having the same shape. The two or more second mounting regions 40Rb are located so as to surround the first mounting region 40Ra.

In the illustrated example, the thermal conductivity of each of the second mounting regions 40Rb is lower than the thermal conductivity of the first mounting region 40Ra. The thermal conductivity of the second outer mounting region 40Rb2 is lower than the thermal conductivity of the second inner mounting region 40Rb1. The thermal conductivity of the third mounting region 40Rc is lower than the thermal conductivity of the second outer mounting region 40Rb2. Thus, the thermal conductivity of each of the mounting regions 40R increases as the mounting region 40R is positioned closer to the center, and decreases as the mounting region 40R is positioned farther from the center. Accordingly, the temperature difference between the plurality of light sources 40 can be reduced. However, depending on the application, the thermal conductivity of each of the mounting regions 40R does not necessarily increase as the mounting region 40R is positioned closer to the center or decrease as the mounting region 40R is positioned farther from the center.

As illustrated in FIG. 3A, in a top view, the area of the first light source 40a is larger than the area of the first upper surface 14as of the first protrusion 14a. More specifically, a part of the first light source 40a overlaps the entire first upper surface 14as of the first protrusion 14a. Similarly, the area of the second light source 40b is larger than the area of the second upper surface 14bs of the second protrusion 14b. More specifically, a part of the second light source 40b overlaps the entire second upper surface 14bs of the second protrusion 14b. With such a configuration, during driving, heat generated by the first light source 40a and the second light sources 40b is easily transferred to the protrusions 14.

As described above, in the light source module 200 according to the present embodiment, the substrate 100 on which the plurality of light sources 40 can be mounted includes the heat dissipation layer 10L including the plurality of protrusions 14 and the insulating member 20. In the heat dissipation layer 10L, the thermal conductivity or the thermal resistance is non-uniformly distributed depending on the arrangement of the light sources 40. Accordingly, the temperatures of the plurality of light sources 40 during driving can be appropriately controlled so that the plurality of light sources 40 have desired operating characteristics during driving.

### Modified Examples of Light Source Module

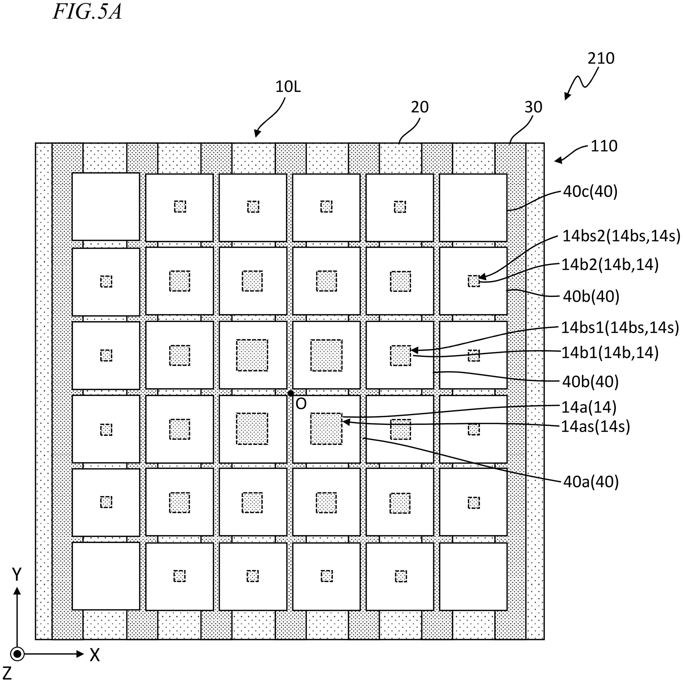

Next, with reference to FIGS. 5A to 5F, five modified examples of the light source module 200 according to the present embodiment will be described.

### First Modified Example

FIG. 5A is a top view schematically illustrating a first modified example of the light source module 200 according to the present embodiment. A light source module 210 illustrated in FIG. 5A includes a substrate 110 and a plurality of light sources 40 mounted on the substrate 110. In the light source module 210 of the first modified example, unlike the light source module 200 according to the present embodiment, the plurality of light sources 40 are arrayed in six rows and six columns. Further, in the light source module 210 of the first modified example, unlike the light source module 200 according to the present embodiment, a plurality of protrusions 14 included in the substrate 110 are arrayed in the six rows and the six columns at positions other than the four corners. The base portion 12, the insulating member 20, the plurality of wirings 30, and the plurality of light sources 40 are as described with reference to FIGS. 1A to 1D, 2A and 2B, 3A and 3B, and 4.

In the substrate 110, the plurality of protrusions 14 include four first protrusions 14a located at the center, and two or more second protrusions 14b located outward of the four first protrusions 14a. Of the plurality of protrusions 14, each of the four first protrusions 14a has the center closest to the reference position O. The two or more second protrusions 14b include at least one second inner protrusion 14b1 located closer to the four first protrusions 14a, and at least one second outer protrusion 14b2 located outward of the second inner protrusion 14b1.

In the illustrated example, the at least one second inner protrusion 14b1 surrounds the four first protrusions 14a, and includes 12 second protrusions 14b having the same shape. Some or all of these 12 second protrusions 14b can have different shapes. The at least one second outer protrusion 14b2 is located at the ends and includes 16 second protrusions 14b having the same shape. Some or all of these 16 second protrusions 14b can have different shapes. The two or more second protrusions 14b are arranged so as to surround the four first protrusions 14a.

Of the two or more second protrusions 14b, the second inner protrusion 14b1 has the second inner upper surface 14bs1, and the second outer protrusion 14b2 has the second outer upper surface 14bs2. In a top view, the two or more second upper surfaces 14bs include at least one second inner upper surface 14bs1 located closer to the four first upper surfaces 14as, and at least one second outer upper surface 14bs2 located outward of the second inner upper surface 14bs1.

In the illustrated example, the area of each second upper surface 14bs is smaller than the area of the first upper surface 14as. The area of the second outer upper surface 14bs2 is smaller than the area of the second inner upper surface 14bs1. Thus, the area of the upper surface 14s of each protrusion 14 increases as the protrusion 14 is positioned closer to the center, and decreases as the protrusion 14 is positioned farther from the center. The larger the area of the upper surface 14s of the protrusions 14, the more effectively heat generated from the light sources 40 during driving is transferred to the base portion 12, so that the temperature difference between the plurality of light sources 40 can be reduced. However, depending on the application, the area of the upper surface 14s of each protrusion 14 does not necessarily have to increase as the protrusion 14 is positioned closer to the center or decrease as the protrusion 14 is positioned farther from the center.

As described above, in the light source module 210 of the first modified example, the substrate 110 has the heat dissipation layer 10L including the plurality of protrusions 14 and the insulating member 20, similarly to the substrate 100 according to the present embodiment. In the heat dissipation layer 10L, the thermal conductivity or the thermal resistance is non-uniformly distributed depending on the arrangement of the light sources 40. Therefore, the temperatures of the plurality of light sources 40 during driving can be appropriately controlled.

### Second Modified Example

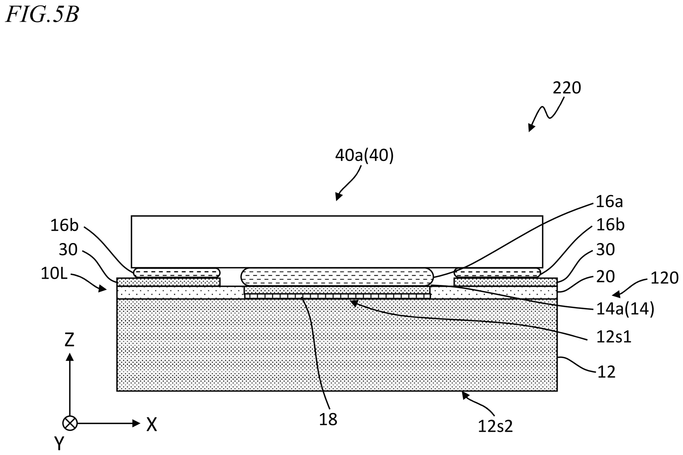

FIG. 5B is a cross-sectional view schematically illustrating a part of the light source module 200 of a second modified example according to the present embodiment. A light source module 220 illustrated in FIG. 5B includes a substrate 120 and the plurality of light sources 40 mounted on the substrate 120. In the light source module 220 of the second modified example, unlike the light source module 200 according to the present embodiment, a bonding member 18 is provided between the base portion 12 and the plurality of protrusions 14 in the substrate 120. The insulating member 20, the plurality of wirings 30, and the plurality of light sources 40 are as described with reference to FIGS. 1A to 1D, 2A and 2B, 3A and 3B, and 4.

In a case in which the plurality of protrusions 14 and the base portion 12 are individual bodies, the plurality of protrusions 14 are fixed to the upper surface 12s1 of the base portion 12 with the bonding member 18. Due to the presence of the bonding member 18, heat transferred from the light sources 40 to the protrusions 14 can be effectively transferred to the base portion 12 in the substrate 120.

As described above, in the light source module 220 of the second modified example, the substrate 120 has the heat dissipation layer 10L including the plurality of protrusions 14 and the insulating member 20, similarly to the substrate 100 according to the present embodiment. In the heat dissipation layer 10L, the thermal conductivity or the thermal resistance is non-uniformly distributed depending on the arrangement of the light sources 40. Therefore, the temperatures of the plurality of light sources 40 during driving can be appropriately controlled.

### Third Modified Example

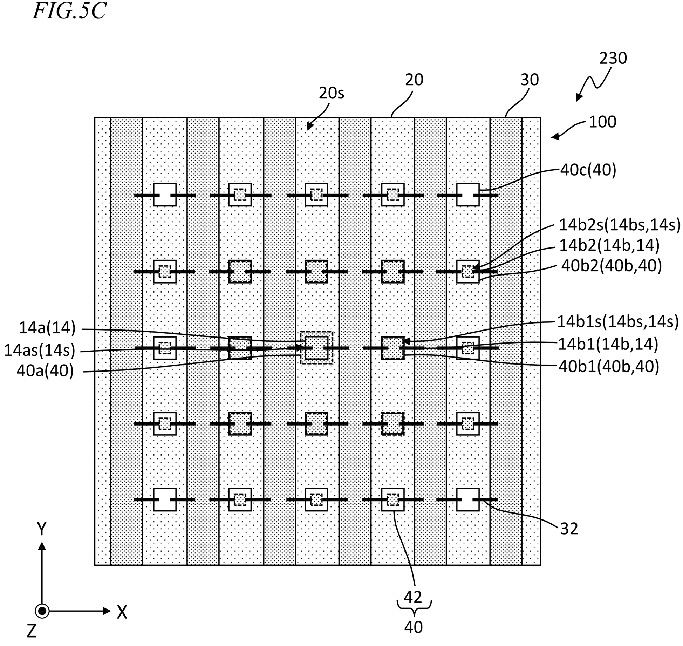

FIG. 5C is a top view schematically illustrating a third modified example of the light source module 200 according to the present embodiment. A light source module 230 illustrated in FIG. 5C includes a substrate 100 and a plurality of light sources 40 mounted on the substrate 100. In the light source module 230 of the third modified example, unlike the light source module 200 according to the present embodiment, each light source 40 is the light-emitting element 42 itself. The light-emitting element 42 is supplied with electric power from the two wirings 30 through the two conductive members 32. Each conductive member 32 can be a wire formed of at least one metal material selected from the group consisting of Cu, Al, Au, CuW, CuMo, and Ag. The base 10, the insulating member 20, and the plurality of wirings 30 are as described with reference to FIGS. 1A to 1D, 2A and 2B, and 3A and 3B.

Because each light source 40 does not include any component other than the light-emitting element 42, reduction in weight of the light source module 230 and manufacturing cost of the light source module 230 can be achieved. Further, because the dimension of the light source module 230 in the Z direction can be reduced, reduction in size of the light source module 230 can be achieved. In a case in which the light source module 230 is encapsulated by a housing, the light-emitting element 42 is also encapsulated.

The light-emitting element 42 as the first light source 40a is bonded to the first upper surface 14as of the first protrusion 14a. The light-emitting element 42 as the second light source 40b is bonded to the second upper surface 14bs of the corresponding second protrusion 14b. The light-emitting element 42 as the third light source 40c is bonded to the upper surfaces 20s of the insulating member 20.

As described above, in the light source module 230 of the third modified example, because each light source 40 does not include any component other than the light-emitting element 42, reduction in the size, weight, and manufacturing cost can be achieved.

### Fourth Modified Example

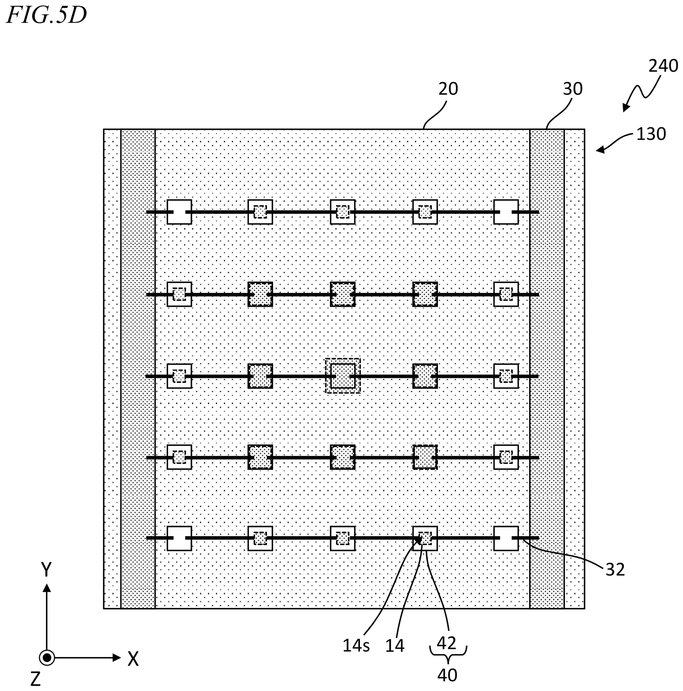

FIG. 5D is a top view schematically illustrating a fourth modified example of the light source module 200 according to the present embodiment. A light source module 240 illustrated in FIG. 5D includes a substrate 130 and a plurality of light sources 40 mounted on the substrate 130. In the light source module 240 of the fourth modified example, unlike the light source module 230 of the third modified example, two or more light sources 40 arranged next to each other in the row direction in the plurality of light sources 40 are electrically connected in series. In the light source module 240 of the fourth modified example, furthermore, unlike the light source module 230 of the third modified example, the substrate 130 includes two wirings 30 having different polarities. The two or more light sources 40 electrically connected in series are electrically connected to the two wirings 30. In a top view, all of the plurality of protrusions 14 are located between the two wirings 30. Similarly, in a top view, all of the plurality of light sources 40 are located between the two wirings 30. The base 10 and the insulating member 20 are as described with reference to FIGS. 1A to 1D, 2A and 2B, and 3A and 3B.

In the illustrated example, the light sources 40 at both ends of the series connection are electrically connected to the two wirings 30, but the electrical connection is not limited to this example. When the light sources 40 at both ends of the series connection are electrically connected to an external power supply device through the conductive members 32 without using the wirings 30, the wirings 30 do not necessarily have to be arranged on the insulating member 20. In the illustrated example, the two or more light sources 40 arranged next to each other in the row direction in the plurality of light sources 40 are electrically connected in series, but the electrical connection is not limited to this example. All of the plurality of light sources 40 can be electrically connected in series.

As described above, in the light source module 240 of the fourth modified example, the number of the wirings 30 can be reduced, and reduction in weight and manufacturing cost can be achieved.

### Fifth Modified Example

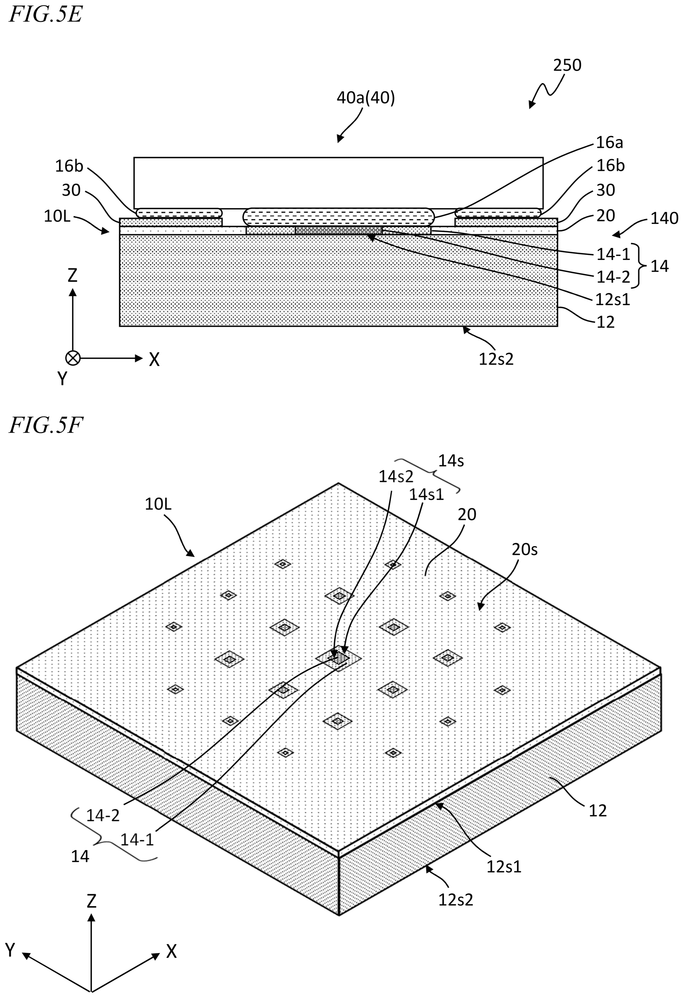

FIG. 5E is a cross-sectional view schematically illustrating a part of a fifth modified example of the light source module 200 according to the present embodiment. A light source module 250 illustrated in FIG. 5E includes a substrate 140 and the plurality of light sources 40 mounted on the substrate 140. FIG. 5F is a perspective view schematically illustrating a configuration in which the plurality of wirings 30 are omitted from the substrate 140 included in the light source module 250 illustrated in FIG. 5E. In the light source module 250 of the fifth modified example, unlike the light source module 200 according to the present embodiment, each protrusion 14 on the substrate 140 includes a first portion 14-1 having a rectangular ring shape and a second portion 14-2 surrounded by the first portion 14-1 as illustrated in FIG. 5F. The first portion 14-1 includes a hollow portion, and the second portion 14-2 fills the hollow portion of the first portion 14-1. The first portion 14-1 can have, for example, a circular ring shape or an elliptical ring shape instead of the rectangular ring shape.

The upper surface 14s of each protrusion 14 has a first region 14s1 that is a surface of the first portion 14-1 and a second region 14s2 that is a surface of the second portion 14-2. The occupancy ratio of the second region 14s2 on the upper surface 14s of each protrusion 14 can be in a range of 10% to 50%, for example.

The thermal conductivity of the first portion 14-1 is higher than the thermal conductivity of the insulating member 20. When the thermal conductivity of the second portion 14-2 is higher than the thermal conductivity of the insulating member 20, the thermal conductivity of the second portion 14-2 can be higher or lower than the thermal conductivity of the first portion 14-1. The material of the first portion 14-1 can be the same as the material of the protrusion 14 described above, for example. The same applies to the material of the second portion 14-2.

On the upper surface 14s of each protrusion 14, the area of the first region 14s1 having the occupancy ratio of 50% or more increases as the protrusion 14 is positioned closer to the center, and decreases as the protrusion 14 is positioned farther from the center. The larger the area of the first region 14s1, the more effectively heat generated from the light source 40 during driving is transferred to the base portion 12, and the temperature difference between the plurality of light sources 40 can be reduced.

When the light source 40 can be arranged corresponding to the upper surface 14s of each protrusion 14, each protrusion 14 including the first portion 14-1 and the second portion 14-2 can be further modified. Each protrusion 14 includes the first portion 14-1, for example, but does not necessarily have to include the second portion 14-2. The expression "each protrusion 14 does not include the second portion 14-2" means that the thermal conductivity of a member arranged in the hollow portion of the first portion 14-1 is the same as the thermal conductivity of the insulating member 20 or is lower than the thermal conductivity of the insulating member 20. For example, the insulating member 20 can be arranged in the hollow portion of the first portion 14-1, similarly to the periphery of the first portion 14-1.

In a case in which each protrusion 14 includes the first portion 14-1 but does not include the second portion 14-2, each protrusion 14 can have, for example, a rectangular ring shape. The rectangular ring shape includes four corner portions located at four corners (upper left, lower left, upper right, and lower right portions) and four link portions connecting the four corner portions (upper, lower, left, and right portions).

When the light source 40 can be arranged corresponding to the upper surface 14s of each protrusion 14, each protrusion 14 having the rectangular ring shape can be further modified. Each protrusion 14 includes, for example, four corner portions of the rectangular ring shape, but does not necessarily have to include four link portions. Alternatively, each protrusion 14 includes four link portions of the rectangular ring shape, but does not necessarily have to include four corner portions. These four link portions can be separated from each other or can be partially in contact with each other.

The shape of each protrusion 14 can be appropriately determined in consideration of alignment when arranging the plurality of light sources 40.

As described above, in the light source module 250 of the fifth modified example, the substrate 140 includes the heat dissipation layer 10L including the plurality of protrusions 14 and the insulating member 20, similarly to the substrate 100 according to the present embodiment. In the heat dissipation layer 10L, the thermal conductivity or the thermal resistance is non-uniformly distributed depending on the arrangement of the light sources 40. Therefore, the temperatures of the plurality of light sources 40 during driving can be appropriately controlled.

### Exposure Device

The light source module 200 according to the present embodiment and the modified examples of the light source module 200 can be used in, for example, an exposure device. The exposure device can be used for manufacturing, for example, a display, a semiconductor device, and a printed circuit board. In the exposure device, a photoresist applied to a workpiece on a support substrate is exposed by ultraviolet light through a photomask having a pattern. The exposed photoresist is developed, and thus a patterned photoresist is obtained. The workpiece on the support substrate is etched via the patterned photoresist, and thus the workpiece on the substrate is patterned. The photoresist is then removed.

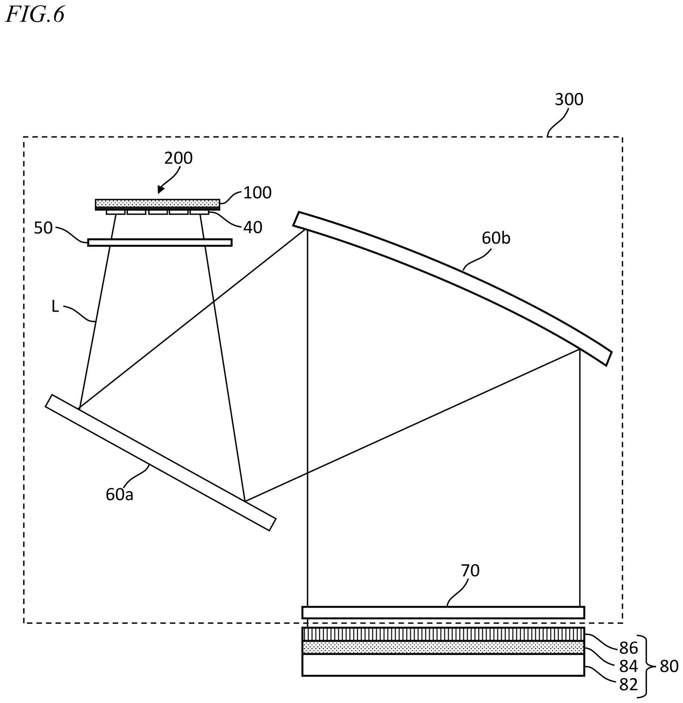

Next, with reference to FIG. 6, a configuration example of the exposure device according to the embodiment of the present disclosure will be described. FIG. 6 is a diagram schematically illustrating a configuration of the exposure device according to an exemplary embodiment of the present disclosure. An exposure device 300 illustrated in FIG. 6 is an example of the exposure device used for manufacturing a display. In FIG. 6, in addition to the exposure device 300, a layered body 80 including a support substrate 82, a workpiece 84, and a photoresist 86 is illustrated. In the layered body 80, the support substrate 82, the workpiece 84, and the photoresist 86 are layered in this order. The support substrate 82 can be, for example, a glass substrate. The workpiece 84 can be formed of, for example, a metal material.

The exposure device 300 includes the light source module 200. In a case in which each light source 40 emits ultraviolet light, the light source module 200 emits ultraviolet light as irradiation light L. A region interposed between two straight lines illustrated in FIG. 6 represents a spread of the irradiation light L. The exposure device 300 can further include a bandpass filter 50 located on an optical path of the irradiation light L emitted from the light source module 200. The bandpass filter 50 has a transmission band that transmits light in a wavelength range effective for exposure of the photoresist 86. A width of the transmission band can be in a range of 355 nm to 375 nm, for example.

The exposure device 300 further includes a plane mirror 60a and a concave mirror 60b located on the optical path of the irradiation light L emitted from the light source module 200. The plane mirror 60a and the concave mirror 60b are examples of optical elements. The irradiation light L emitted from the light source module 200 passes through the bandpass filter 50 and is reflected by the plane mirror 60a and the concave mirror 60b in this order to have an area suitable for exposure of the photoresist 86.

The exposure device 300 further includes a photomask 70 located on the optical path of the irradiation light L emitted from the light source module 200 via the plane mirror 60a and the concave mirror 60b. The photoresist 86 included in the layered body 80 is arranged in a state of being close to or in contact with the photomask 70. The photoresist 86 is exposed to the irradiation light L through the photomask 70. In a case in which the entire photoresist 86 cannot be exposed at once, after a portion of the photoresist 86 is exposed, the layered body 80 can be shifted in a lateral direction to expose the remaining portion of the photoresist 86.

In the illustrated example, the exposure device 300 is an exposure device used for manufacturing a display, but the exposure device 300 is not limited to this example. The exposure device 300 can be, for example, an exposure device used for manufacturing a semiconductor device and a printed circuit board. In this case, the exposure device 300 can include, for example, a condenser lens, the photomask 70, and a projection lens in this order on the optical path of the irradiation light L emitted from the light source module 200, in addition to the light source module 200 and the bandpass filter 50. Alternatively, the exposure device 300 can include, for example, a digital micromirror device (DMD) and a projection lens in this order on the optical path of the irradiation light L emitted from the light source module 200, in addition to the light source module 200 and the bandpass filter 50. This exposure device 300 is a direct imaging exposure device that exposes the photoresist 86 by using the DMD instead of the photomask 70.

### Shift Amount of Peak Wavelength of Light Emitted From LED Due to Temperature Change

The inventors of the present invention have confirmed that the amount of shift in the peak wavelength of light emitted from an LED due to a temperature change tends to increase as the peak wavelength decreases. Table 1 shows the amounts of shift in the peak wavelengths of the light emitted from LED 1 (ultraviolet LED), LED 2 (blue LED), and LED 3 (green LED) in a case in which the ambient temperature changes by 10°C from 50°C to 60°C for the LEDs 1 to 3.

**[Table 1]**

| Ambient temperature | LED1 | LED2 | LED3 |
|---|---|---|---|
| 50°C | 366.21nm | 455.96nm | 527.80nm |
| 60°C | 366.72nm | 456.33nm | 528.12nm |
| Amount of shift | 0.51nm | 0.37nm | 0.32nm |

As shown in Table 1, when the ambient temperature changed by 10°C from 50°C to 60°C, the shift amounts of the peak wavelengths of the light emitted from the LED 1, the LED 2, and the LED 3 were 0.51 nm, 0.37 nm, and 0.32 nm, respectively. From this, as the peak wavelength of light emitted from an LED is shorter (the peak wavelength is shorter in the LEDs 1 and 2 than in the LED 3, while being shorter in the LED 1 than in the LED 2), in the present embodiment and the modified examples thereof, the temperatures of the plurality of light sources 40 during driving can be more appropriately controlled so that the plurality of light sources 40 have desired operating characteristics during driving, and this makes it possible to reduce unevenness in the wavelength or reduce unevenness in the intensity.

The present disclosure includes the substrate on which the plurality of light sources can be mounted, the light source module, and the exposure device described in the following items.

The substrate and the light source module of the present disclosure can be used for light-emitting devices in various applications. The exposure device of the present disclosure can be used for exposure of a photoresist.

## Claims

1. A substrate on which a plurality of light sources are to be mounted, the substrate comprising:
a base comprising a base portion and a plurality of protrusions, the base portion having a flat surface, and each of the plurality of protrusion being surrounded by the flat surface and having an upper surface located above the flat surface;
an insulating member arranged on the flat surface, the insulating member having a thermal conductivity lower than a thermal conductivity of the base; and
a wiring arranged on the insulating member, wherein
the plurality of protrusions comprise, in a top view,
a first protrusion located at a center and having a first upper surface, and
two or more second protrusions located outward of the first protrusion, each of the two or more second protrusions having a second upper surface, the second upper surface having an area smaller than an area of the first upper surface.

2. The substrate according to claim 1,
wherein the plurality of protrusions are formed of a material having an isotropic thermal conductivity.

3. The substrate according to claim 1 or 2,
wherein the base portion and the plurality of protrusions form a single monolithic body.

4. The substrate according to claim 1 or 2,
wherein the base portion and the plurality of protrusions are individual bodies.

5. The substrate according to claim 4,
wherein bonding members are provided between the base portion and the plurality of protrusions.

6. The substrate according to any one of claims 1 to 5,
wherein the two or more second protrusions surround the first protrusion.

7. The substrate according to any one of claims 1 to 6, wherein, in the top view,
two or more of the second upper surfaces comprise at least one second inner upper surface located closer to the first upper surface, and at least one second outer upper surface located outward of the second inner upper surface, and
the second outer upper surface has an area smaller than an area of the second inner upper surface.

8. A light source module comprising:
the substrate according to any one of claims 1 to 7; and
the plurality of light sources mounted on the substrate, wherein
the plurality of light sources comprise,
a first light source mounted on the first upper surface, and
two or more second light sources each mounted on a corresponding one of the two or more second upper surfaces.

9. The light source module according to claim 8, wherein, in a top view,
an area of the first light source is larger than an area of the first upper surface, and
an area of one of the two or more second light sources is larger than an area of one of the two or more second upper surfaces.

10. The light source module according to claim 8 or 9,
wherein the wiring is electrically connected to at least one of the plurality of light sources, while not being electrically connected to the base.

11. The light source module according to any one of claims 8 to 10,
wherein light emitted from each of the plurality of light sources is ultraviolet light.

12. An exposure device comprising the light source module according to any of claims 8 to 11.
